# EUROPEAN PATENT SPECIFICATION

(11) **EP 4 485 531 B1**
(45) Date of publication and mention of the grant of the patent: **24.12.2025**
(21) Application number: 23212791.0
(22) Date of filing: 28.11.2023
(51) Int. Cl.: H01L 23/522, H10D 1/68

(54) **INTEGRATED CAPACITOR**
INTEGRIERTER KONDENSATOR
CONDENSATEUR INTÉGRÉ

(30) Priority: 26.06.2023 US 202318214244
(43) Date of publication of application: 01.01.2025
(73) Proprietor: INTEL Corporation, Santa Clara, CA 95054 (US)
(72) Inventor: BAUMGARTNER, Peter, 81929 Munich (DE); YAKKEGONDI VIRUPAKSHAPPA, Mamatha, 81673 Munich (DE); MORAN GUIZAN, Carla, 81541 Munich (DE); SACHITHANANDAN, Roshini, 81545 Munich (DE); RIESS, Philipp, 81541 Munich (DE); LANGENBUCH, Michael, 81825 Munich (DE); JENSEN, Jonathan C., Greenville, 29607 (US)
(74) Representative: HGF

(56) References cited:
- US-A1- 2010 123 213
- US-B1- 6 465 832

## Description

### TECHNICAL FIELD

Embodiments of the disclosure are in the field of advanced integrated circuit structure fabrication and, in particular, integrated capacitors.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

US 6,465,832 B1 discloses a small sized lower power loss capacitor having low parasitic resistance, obtained by adopting metal wires as wires in a line and space structure, to utilize capacitances between adjacent metal wires.

US 2010/0123213 A1 discloses metal-insulator-metal capacitors that are formed in integrated circuit dielectric stacks.

Variability in conventional and currently known fabrication processes may limit the possibility to further extend them into smaller and smaller nodes. Consequently, fabrication of the functional components needed for future technology nodes may require the introduction of new methodologies or the integration of new technologies in current fabrication processes or in place of current fabrication processes.

### SUMMARY

Embodiments of the invention are set out in the appended claims.

### BRIEF DESCRIPTION OF THE DRAWINGS

Figure 1 illustrates an angled cross-sectional view of an integrated capacitor structure.
Figure 2 illustrates an angled cross-sectional view of an integrated capacitor structure, in accordance with an embodiment of the present disclosure.
Figure 3 is a plot including exemplary simulations showing the benefit of the capacitor configurations of Figure 2, in accordance with an embodiment of the present disclosure.
Figure 4 illustrates an angled cross-sectional view of an integrated capacitor structure, in accordance with an embodiment of the present disclosure.
Figure 5 is a plot including simulated (EM simulation) capacitance, resistance and Q factors versus frequency for different capacitors, in accordance with an embodiment of the present disclosure.
Figure 6 illustrates a cross-sectional view of an on-die integrated capacitor in a power delivery system and a corresponding circuit schematic, in accordance with an embodiment of the present disclosure.
Figure 7 illustrates a cross-sectional view of an integrated circuit structure having four metallization layers with a metal line composition and pitch above two metallization layers with a differing metal line composition and smaller pitch, in accordance with an embodiment of the present disclosure.
Figure 8 illustrates a computing device in accordance with one implementation of the disclosure.
Figure 9 illustrates an interposer that includes one or more embodiments of the disclosure.
Figure 10 is an isometric view of a mobile computing platform employing an IC fabricated according to one or more processes described herein or including one or more features described herein, in accordance with an embodiment of the present disclosure.
Figure 11 illustrates a cross-sectional view of a flip-chip mounted die, in accordance with an embodiment of the present disclosure.

### DESCRIPTION OF THE EMBODIMENTS

Integrated capacitors are described. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

The following detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

Terminology. The following paragraphs provide definitions or context for terms found in this disclosure (including the appended claims):

"Comprising." This term is open-ended. As used in the appended claims, this term does not foreclose additional structure or operations.

"Configured To." Various units or components may be described or claimed as "configured to" perform a task or tasks. In such contexts, "configured to" is used to connote structure by indicating that the units or components include structure that performs those task or tasks during operation. As such, the unit or component can be said to be configured to perform the task even when the specified unit or component is not currently operational (e.g., is not on or active). Reciting that a unit or circuit or component is "configured to" perform one or more tasks is expressly intended not to invoke 35 U.S.C. §112, sixth paragraph, for that unit or component.

"First," "Second," etc. As used herein, these terms are used as labels for nouns that they precede, and do not imply any type of ordering (e.g., spatial, temporal, logical, etc.).

"Coupled" - The following description refers to elements or nodes or features being "coupled" together. As used herein, unless expressly stated otherwise, "coupled" means that one element or node or feature is directly or indirectly joined to (or directly or indirectly communicates with) another element or node or feature, and not necessarily mechanically.

In addition, certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", "side", "outboard", and "inboard" describe the orientation or location or both of portions of the component within a consistent but arbitrary frame of reference which is made clear by reference to the text and the associated drawings describing the component under discussion. Such terminology may include the words specifically mentioned above, derivatives thereof, and words of similar import.

"Inhibit" - As used herein, inhibit is used to describe a reducing or minimizing effect. When a component or feature is described as inhibiting an action, motion, or condition it may completely prevent the result or outcome or future state completely. Additionally, "inhibit" can also refer to a reduction or lessening of the outcome, performance, or effect which might otherwise occur. Accordingly, when a component, element, or feature is referred to as inhibiting a result or state, it need not completely prevent or eliminate the result or state.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back-end-of-line (BEOL) semiconductor processing and structures. BEOL is the second portion of IC fabrication where the individual devices (e.g., transistors, capacitors, resistors, etc.) get interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

In accordance with one or more embodiments of the present disclosure, integrated capacitors are described. One or more embodiments are directed to a high performance and low tolerance integrated capacitor. One or more embodiments are directed to a hybrid finger and sandwich mmW high Q capacitor.

In a first aspect, a high performance and low tolerance integrated capacitor is described.

To provide context, passive inductive and capacitive devices are very important for RF and mmW circuits. Capacitors are realized by tightly spaced metal plates or fingers and therefore have relatively large process variations. Inductive devices, with their larger dimensions, have a much lower variation and the tolerance of the capacitor devices is therefore often limiting the circuits. Another problem is the series inductance of capacitors, which can dominate the impedance of the device and convert a capacitor to an inductor at very high frequencies.

Previous approaches to integrating capacitors have included implementing circuit techniques to address the above issues, e.g., adding tuning circuits, increasing the bandwidth of circuits. However, the circuit techniques increase the power consumption and area of the implementation.

In accordance with one or more embodiments of the present disclosure, the tolerance of a capacitor is improved by adding additional dielectric and metallic layers on top or below capacitor finger structures. With these layers, an additional capacitor contributor is added, which has low variation (good control of layer thickness versus lithographically defined distances) and is not correlated to the initial variation. In an embodiment, such an arrangement leads to an overall reduction of the tolerance.

Advantages of implementing one or more embodiments described herein can include that the fabrication of device enhancement circuits with lower power consumption and higher frequencies for improved data rate can be designed.

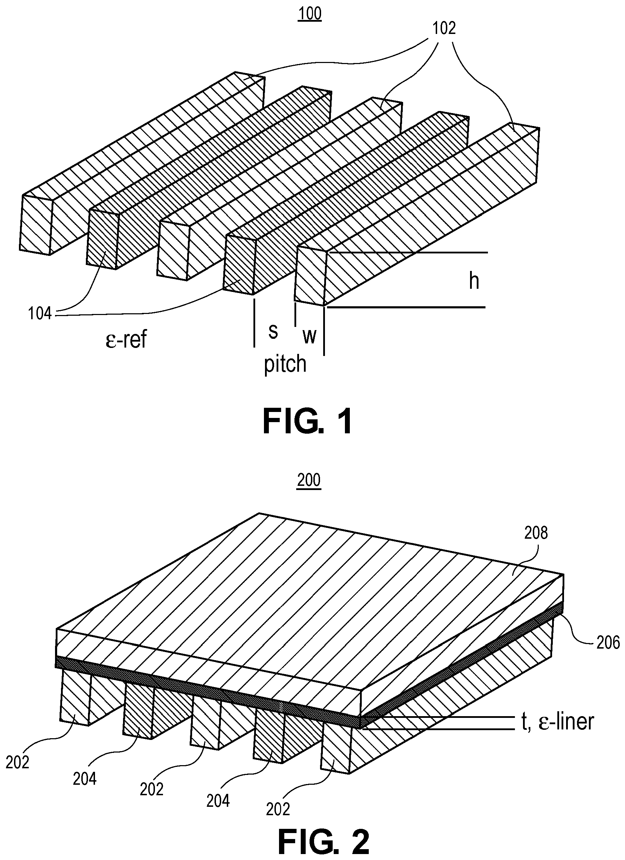

As a comparative example, Figure 1 illustrates an angled cross-sectional view of an integrated capacitor structure.

Referring to Figure 1, an integrated capacitor structure 100 includes alternating first metal lines 102 and second metal lines 104, which may be referred to as fingers. The first metal lines 102 are coupled together to a first polarity, e.g., at a location into or out of the page. The second metal lines 104 are coupled together to a second polarity opposite the first polarity, e.g., at a location into or out of the page. The first metal lines 102 and the second metal lines 104 are included in a dielectric layer, such as a BEOL dielectric layer, referred to generally as ε-ref. Individual ones of the first metal lines 102 and the second metal lines 104 can have a spacing (s), a width (W), a height (h), and a pitch, all of which contribute to the overall capacitance of the integrated capacitor structure 100.

In contrast to Figure 1, Figure 2 illustrates an angled cross-sectional view of an integrated capacitor structure, in accordance with an embodiment of the present disclosure.

Referring to Figure 2, an integrated capacitor structure 200 includes alternating first metal lines 202 and second metal lines 204, which may be referred to as fingers. The first metal lines 202 are coupled together to a first polarity, e.g., at a location into or out of the page. The second metal lines 204 are coupled together to a second polarity opposite the first polarity, e.g., at a location into or out of the page. The first metal lines 202 and the second metal lines 204 are included in a dielectric layer, such as a BEOL dielectric layer. Individual ones of the first metal lines 202 and the second metal lines 204 can be as described in association with integrated capacitor structure 100 of Figure 1. In an embodiment, integrated capacitor structure 200 includes at least one metal plate 208 and intervening dielectric liner layer 206 (the latter showing having a thickness, t, and a liner permitivity, ε-liner).

Referring again to Figure 2, in one embodiment, a single metal plate 208 and intervening dielectric liner layer 206 pair are included over a "finger" capacitor 202/204, as is depicted. In another embodiment, one or more additional metal plate and intervening dielectric liner layer pairs are included over the metal plate 208 and intervening dielectric liner layer 206. In another embodiment, one or more metal plate and intervening dielectric liner layer pairs are included below a "finger" capacitor. In another embodiment, one or more metal plate and intervening dielectric liner layer pairs are included both above and below a "finger" capacitor.

With reference again to Figures 1 and 2, a state-of-the-art finger capacitor for integrated CMOS capacitors is shown in Figure 1. A dielectric with constant dielectric constant is assumed, which was also used in the simulation described below. It is to be appreciated that the capacitor can be processed layers with different dielectrics. As shown in Figure 2, in accordance with an embodiment of the present disclosure, a thin dielectric 206 (preferably with a relatively higher dielectric constant than the surrounding dielectric layer) and metallic plate are added to a finger structure. The dielectric and metal can be above, below or above and below the finger structure. In an embodiment, the metal plate is typically floating and leads to an increase of the capacitance density, since both polarity fingers couple with high capacitance to the plate.

In an embodiment, this configuration of a capacitor structure described in association with Figure 2 can have several advantages. The capacitor density can be increased by the additional capacitor component. The added processing operations include only added thin layers and do not require high resolution lithography. The processing operations are therefore inexpensive, and also existing layers in the process might be used (e.g. barrier layers). The process control for the thickness of such layers can be very good and lower tolerance. The metal plate can reduce the series inductance of fingers (e.g., the inductance of a tracer over a ground plane, which decreases with the distance to plane). Since the metal can be patterned with course design rules, the thickness can be increased to reduce the sheet resistance. Also very thin layers could be chosen with good effectiveness on cap density and tolerance if low added height is a priority for the integration scheme. With the usage of less metal finger layers (exploiting the higher capacitor density), the free metal layers can be used for routing. Also, parasitic capacitance can be reduced.

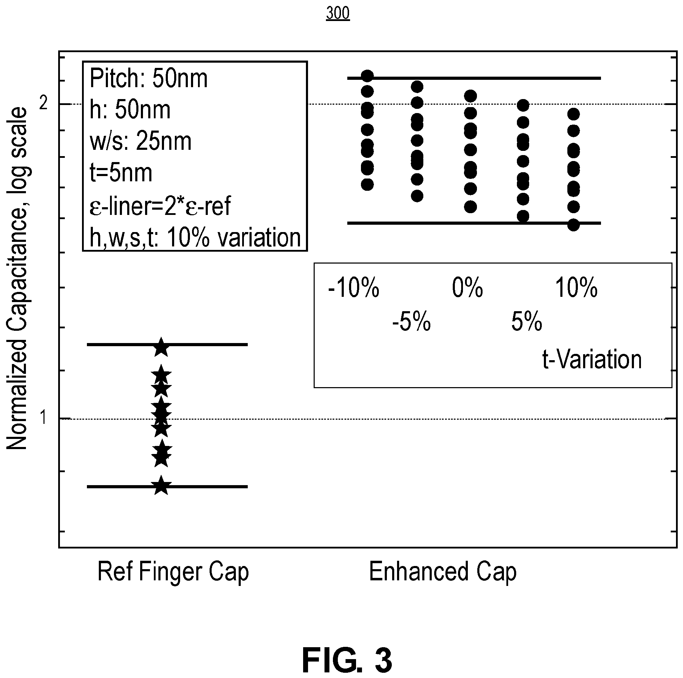

Figure 3 is a plot 300 including exemplary simulations showing the benefit of the capacitor configurations of Figure 2, in accordance with an embodiment of the present disclosure.

Referring to plot 300 of Figure 3, simulated capacitor values for a reference finger capacitor (e.g., Figure 1) and an enhanced capacitor (e.g., Figure 2) are included. The parameters are shown in the insert. A fixed pitch of 50nm was used, divided into a width of 25nm and a space of 25nm. The height of the metal lines is 50nm. The geometrical parameters were varied by 10% (pitch is kept constant) and each simulated capacitor value is shown. The added layers of Figure 2 result in an capacitor increase of 80% in this example. Also, it is clearly visible that the impact of w/s and h variation on the capacitor value is reduced (for a constant t-Variation the spread is smaller than in the reference capacitor). The thickness variation of the additional dielectric also contributes to the capacitor variation, but with the tighter control of this thickness an overall reduction of the variation can be achieved. For the enhanced capacitor, a liner thickness of 5nm and a dielectric capacitance of double the reference was used. The geometric parameters are varied by 10% and the resulting capacitor values are shown in the plot. Log scaling allows easy assessment of variation (constant percent variation results in same y-axis spread independent of base value). Possible applications of the capacitor structure of Figure 2 can include RF, mmW and/or analog circuits that can benefit from the availability of such an enhanced capacitor.

In an embodiment, the first metal lines 202 and the second metal lines 204 are composed of a conductive material such as, but not limited to, Cu, Al, Ti, Zr, Hf, V, Ru, Co, Ni, Pd, Pt, W, Ag, Au or alloys thereof, and may include a conductive liner or barrier around such a conductive material.

In an embodiment, the surrounding dielectric (ε-ref) is a low-k dielectric layer, such as found in a BEOL structure. In one such embodiment, the low-k dielectric layer is composed of a doped oxide of silicon, a fluorinated oxide of silicon, or a carbon doped oxide of silicon. In another embodiment, the surrounding dielectric (ε-ref) is composed of an oxide of silicon (e.g., silicon dioxide (SiO₂)).

In an embodiment, the dielectric liner layer 206 is or includes a high-k material. For example, in one embodiment, the dielectric liner layer 206 is composed of a material such as, but not limited to, hafnium oxide, hafnium oxy-nitride, hafnium silicate, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, or a combination thereof.

In an embodiment, the metal plate 208 is composed of a metal layer such as, but not limited to, a metal nitride (TiN or TaN), a metal carbide, a metal silicide, a metal aluminide, hafnium, zirconium, titanium, tantalum, aluminum, ruthenium, palladium, platinum, cobalt, nickel, copper or a conductive metal oxide.

In a second aspect, a hybrid finger and sandwich mmW high Q capacitor is described.

To provide context, passive inductive and capacitive devices are very important for RF and mmW circuits. Capacitors are typically realized by tightly spaced metal fingers. This configuration offers high capacitance density, around 50% metal density which is ideal for the metal process using CMP polishing. The Q factor of capacitors is proportional to ~1/frequency at high frequencies. For mmW circuits and especially for next generation >100GHz application the Q factor of capacitors has a high priority to enable circuits with low power consumption and low noise.

In previous approaches, the capacitors fingers have been realized with thicker metal layers, with larger design rules, to reduce resistance. It is also possible to reduce the unit size of the capacitors to create caps with shorter fingers. In an embodiment, to realize larger capacitors, these smaller units can be combined. Using thicker metals with larger pitches leads to a strong reduction of capacitor density and therefore increased area.

In accordance with one or more embodiments of the present disclosure, alternating finger structures are combined with capacitor plates. The plates and fingers are connected by vias to reduce the series resistance. The capacitor is therefore a combination of a finger cap, utilizing the lateral capacitance between fingers and a sandwich metal cap, utilizing the vertical capacitance.

Advantages to implementing the capacitor plates, which are connected by vias to the finger, can include significantly reducing the series resistance of the fingers. Therefore, the high density of the finger capacitors is combined with the low resistance of the sandwich capacitor plates.

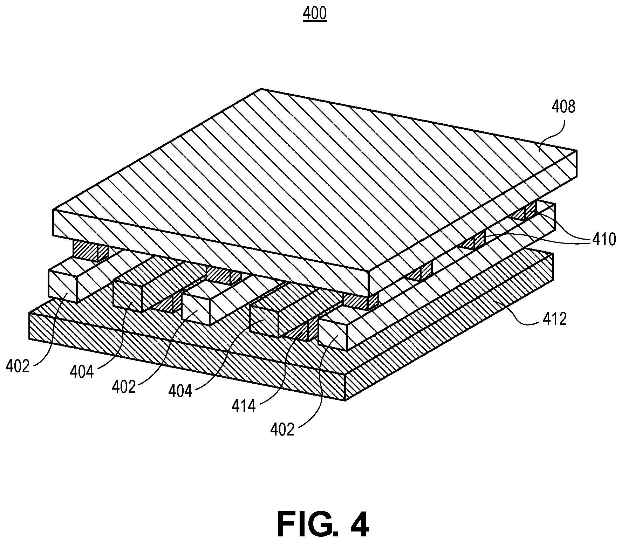

In contrast to Figure 1 described above, Figure 4 illustrates an angled cross-sectional view of an integrated capacitor structure, in accordance with an embodiment of the present disclosure.

Referring to Figure 4, an integrated capacitor structure 400 includes alternating first metal lines 402 and second metal lines 404, which may be referred to as fingers. The first metal lines 402 are coupled together to a first polarity, e.g., at a location into or out of the page. The second metal lines 404 are coupled together to a second polarity opposite the first polarity, e.g., at a location into or out of the page. The first metal lines 402 and the second metal lines 404 are included in a dielectric layer, such as a BEOL dielectric layer. Individual ones of the first metal lines 402 and the second metal lines 404 can be as described in association with integrated capacitor structure 100 of Figure 1. In an embodiment, integrated capacitor structure 400 includes a first metal plate 408 and a second metal plate 412. The first metal plate 408 is above the first metal lines 402 and second metal lines 404 and is coupled to the first metal lines 402 by first vias 410. The first metal plate 408 and the first metal lines 402 have the same polarity, as indicated by the same shading. The second metal plate 412 is below the first metal lines 402 and second metal lines 404 and is coupled to the second metal lines 404 by second vias 414. The second metal plate 412 and the second metal lines 404 have the same polarity, as indicated by the same shading. The polarity of the second metal plate 412/second metal lines 404 is opposite the polarity of the first metal plate 408/first metal lines 402.

Referring again to Figure 4, in an embodiment, fingers and plates with same polarity are connected by a dense via arrangement. Different configurations of capacitors can be realized to adapt the device to the circuit requirements, available metal stack and design rules. With the following nomenclature the configurations can be easily described: P: Plate, F: Finger, Fv: Finger with vertical orientation, Fh:Finger with horizontal orientation. A configurations can include: P-F-P (as shown in Figure 4), P-F-P-F-P (for a capacitor using 5 metal layers), P-F-F-P, P-Fv-P-Fv-P (parallel fingers), P-Fv-P-Fh-P (fingers 90° rotated), P-Fv-Fv-P, P-Fh-Fv-P etc. The optimal choice depends for example on number of used metals, preferred metal orientation, and connection of the capacitor pins.

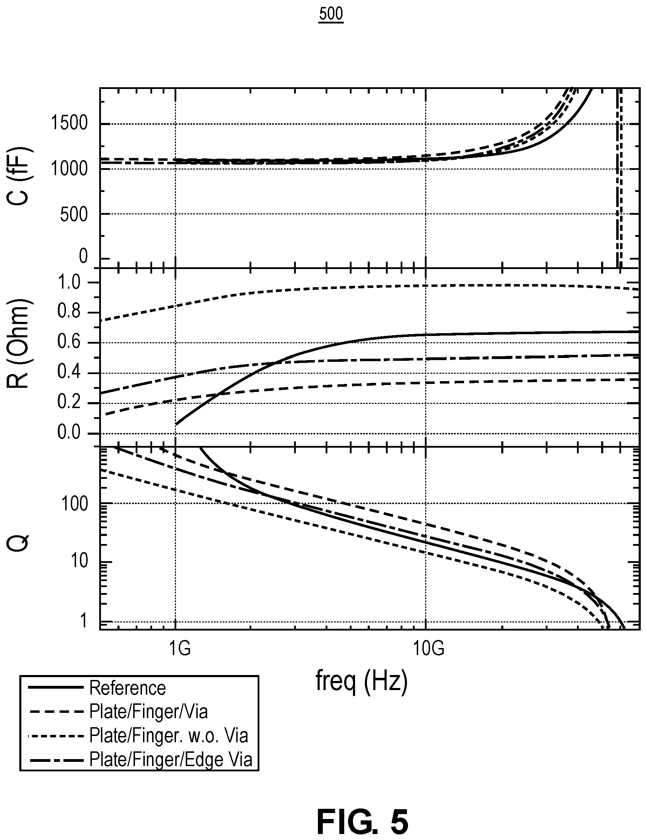

In an embodiment, to evaluate the benefit of implementing embodiments described herein, the S-parameters of different capacitor layouts with EM simulations and calculated Cap, Series resistance and Q factor over frequency were simulated. As an example, Figure 5 is a plot 500 including simulated (EM simulation) capacitance, resistance and Q factors versus frequency for different capacitors, in accordance with an embodiment of the present disclosure. Embodiments described herein show strongly reduced resistance and improve Q factor. Variants with reduced vias show the importance of the via connections.

The simulated capacitors had the following configurations: (1) Standard finger capacitor with 5 Layers: Fv-Fv-Fv-Fv-Fv (Reference); (2) Plate/Finger capacitor with full via connection (disclosure): P-Fv-P-Fv-P; (3) Plate/Finger capacitor without vias; (4) Plate/Finger cap, via connection at the edge of the fingers. The geometrical dimensions of the caps were adjusted to give the same electrical capacitance. The series resistance of the capacitor is reduced by a factor of 2 for embodiments described herein which directly translates to a factor 2 improved Q factor. The capacitor versions without via and via at the edge of the fingers have higher resistance values and show, that a good via connection to the plate can be important.

In an embodiment, if larger capacitance values are needed, a cheesing and segmentation approach for the plates can be used to reduce the metal density. Possible applications of the capacitor structure of Figure 2 can include RF, mmW and/or analog circuits that can benefit from the availability of such an enhanced capacitor.

In an embodiment, the first metal lines 402 and the second metal lines 404 are composed of a conductive material such as, but not limited to, Cu, Al, Ti, Zr, Hf, V, Ru, Co, Ni, Pd, Pt, W, Ag, Au or alloys thereof, and may include a conductive liner or barrier around such a conductive material.

In an embodiment, the surrounding dielectric (ε-ref) is a low-k dielectric layer, such as found in a BEOL structure. In one such embodiment, the low-k dielectric layer is composed of a doped oxide of silicon, a fluorinated oxide of silicon, or a carbon doped oxide of silicon. In another embodiment, the surrounding dielectric (ε-ref) is composed of an oxide of silicon (e.g., silicon dioxide (SiO₂)).

In an embodiment, the metal plates 408 and 412 are composed of a metal layer such as, but not limited to, a metal nitride (TiN or TaN), a metal carbide, a metal silicide, a metal aluminide, hafnium, zirconium, titanium, tantalum, aluminum, ruthenium, palladium, platinum, cobalt, nickel, copper or a conductive metal oxide.

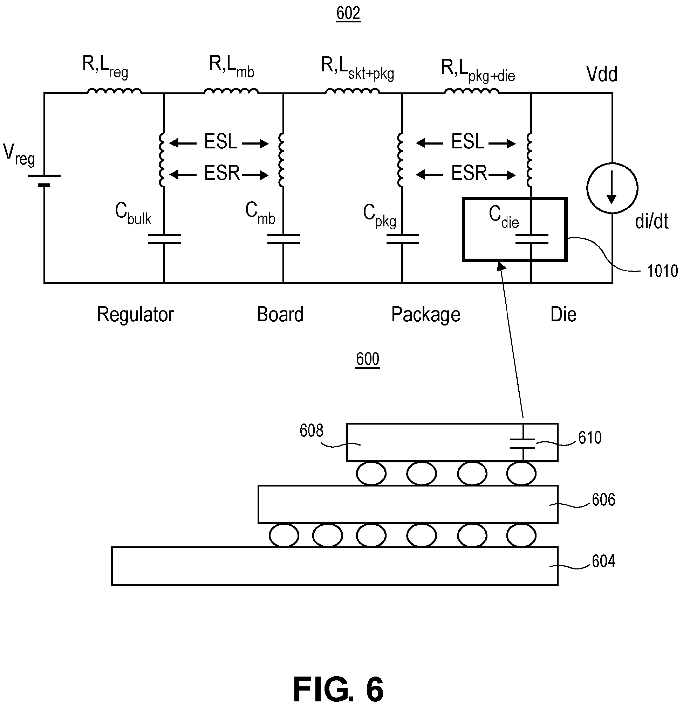

In another aspect, embodiments described herein can be implemented as an on-die integrated capacitor for use in a power delivery system. As an example, Figure 6 illustrates a cross-sectional view of an on-die integrated capacitor in a power delivery system 600 and a corresponding circuit schematic 602, in accordance with an embodiment of the present disclosure.

Referring to Figure 6, the power delivery system 600 includes a board 604, a package 606 coupled to the board 604, and a die 608 coupled to the package 606. The die 608 includes an on-die integrated capacitor 610, such as an integrated capacitor described above in association with Figures 2-5.

In another aspect, back-end-of-line (BEOL) layers of integrated circuits commonly include electrically conductive microelectronic structures, which are known in the art as vias, to electrically connect metal lines or other interconnects above the vias to metal lines or other interconnects below the vias. In accordance with one or more embodiments of the present disclosure, an integrated capacitor, such as described above in association with Figures 2-5, can be included in a BEOL structure of an integrated circuit.

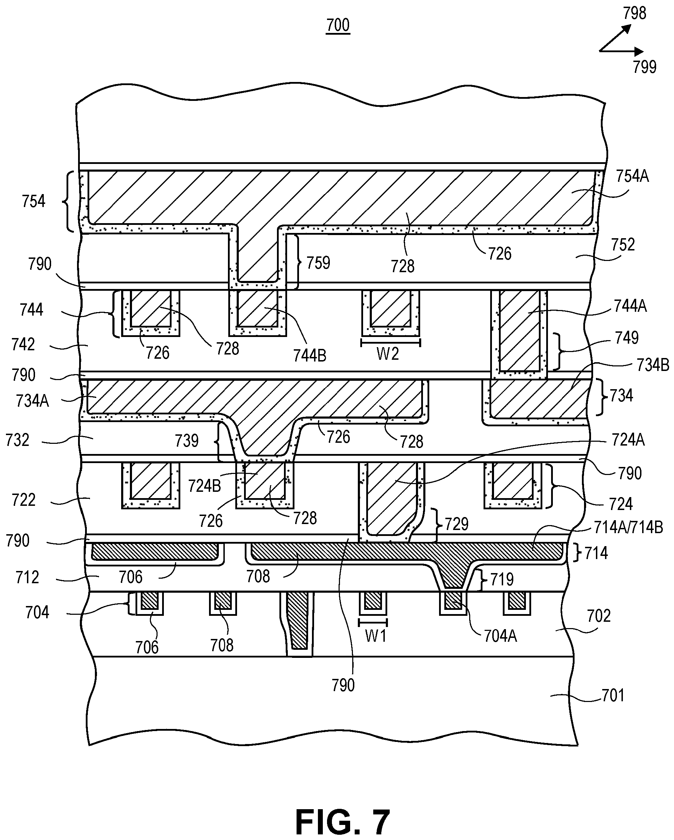

As an exemplary but non-limiting BEOL structure, Figure 7 illustrates a cross-sectional view of an integrated circuit structure having four metallization layers with a metal line composition and pitch above two metallization layers with a differing metal line composition and smaller pitch, in accordance with an embodiment of the present disclosure. It is to be appreciated that an integrated capacitor according to embodiments described above (e.g., Figures 2-5) may be integrated into one or more layers of the integrated circuit structure described below in association with Figure 7.

Referring to Figure 7, an integrated circuit structure 700 includes a first plurality of conductive interconnect lines 704 in and spaced apart by a first inter-layer dielectric (ILD) layer 702 above a substrate 701. Individual ones of the first plurality of conductive interconnect lines 704 include a first conductive barrier material 706 along sidewalls and a bottom of a first conductive fill material 708. Individual ones of the first plurality of conductive interconnect lines 704 are along a first direction 798 (e.g., into and out of the page).

A second plurality of conductive interconnect lines 714 is in and spaced apart by a second ILD layer 712 above the first ILD layer 702. Individual ones of the second plurality of conductive interconnect lines 714 include the first conductive barrier material 706 along sidewalls and a bottom of the first conductive fill material 708. Individual ones of the second plurality of conductive interconnect lines 714 are along a second direction 799 orthogonal to the first direction 798.

A third plurality of conductive interconnect lines 724 is in and spaced apart by a third ILD layer 722 above the second ILD layer 712. Individual ones of the third plurality of conductive interconnect lines 724 include a second conductive barrier material 726 along sidewalls and a bottom of a second conductive fill material 728. The second conductive fill material 728 is different in composition from the first conductive fill material 708. Individual ones of the third plurality of conductive interconnect lines 724 are along the first direction 798.

A fourth plurality of conductive interconnect lines 734 is in and spaced apart by a fourth ILD layer 732 above the third ILD layer 722. Individual ones of the fourth plurality of conductive interconnect lines 734 include the second conductive barrier material 726 along sidewalls and a bottom of the second conductive fill material 728. Individual ones of the fourth plurality of conductive interconnect lines 734 are along the second direction 799.

A fifth plurality of conductive interconnect lines 744 is in and spaced apart by a fifth ILD layer 742 above the fourth ILD layer 732. Individual ones of the fifth plurality of conductive interconnect lines 744 include the second conductive barrier material 726 along sidewalls and a bottom of the second conductive fill material 728. Individual ones of the fifth plurality of conductive interconnect lines 744 are along the first direction 798.

A sixth plurality of conductive interconnect lines 754 is in and spaced apart by a sixth ILD layer 752 above the fifth ILD layer 742. Individual ones of the sixth plurality of conductive interconnect lines 754 include the second conductive barrier material 726 along sidewalls and a bottom of the second conductive fill material 728. Individual ones of the sixth plurality of conductive interconnect lines 754 are along the second direction 799.

In an embodiment, the second conductive fill material 728 consists essentially of copper, and the first conductive fill material 708 consists essentially of cobalt. In an embodiment, the first conductive fill material 708 includes copper having a first concentration of a dopant impurity atom, and the second conductive fill material 728 includes copper having a second concentration of the dopant impurity atom, the second concentration of the dopant impurity atom less than the first concentration of the dopant impurity atom.

In an embodiment, the first conductive barrier material 706 is different in composition from the second conductive barrier material 726. In another embodiment, the first conductive barrier material 706 and the second conductive barrier material 726 have the same composition.

In an embodiment, a first conductive via 719 is on and electrically coupled to an individual one 704A of the first plurality of conductive interconnect lines 704. An individual one 714A of the second plurality of conductive interconnect lines 714 is on and electrically coupled to the first conductive via 719.

A second conductive via 729 is on and electrically coupled to an individual one 714B of the second plurality of conductive interconnect lines 714. An individual one 724A of the third plurality of conductive interconnect lines 724 is on and electrically coupled to the second conductive via 729.

A third conductive via 739 is on and electrically coupled to an individual one 724B of the third plurality of conductive interconnect lines 724. An individual one 734A of the fourth plurality of conductive interconnect lines 734 is on and electrically coupled to the third conductive via 739.

A fourth conductive via 749 is on and electrically coupled to an individual one 734B of the fourth plurality of conductive interconnect lines 734. An individual one 744A of the fifth plurality of conductive interconnect lines 744 is on and electrically coupled to the fourth conductive via 749.

A fifth conductive via 759 is on and electrically coupled to an individual one 744B of the fifth plurality of conductive interconnect lines 744. An individual one 754A of the sixth plurality of conductive interconnect lines 754 is on and electrically coupled to the fifth conductive via 759.

In one embodiment, the first conductive via 719 includes the first conductive barrier material 706 along sidewalls and a bottom of the first conductive fill material 708. The second 729, third 739, fourth 749 and fifth 759 conductive vias include the second conductive barrier material 726 along sidewalls and a bottom of the second conductive fill material 728.

In an embodiment, the first 702, second 712, third 722, fourth 732, fifth 742 and sixth 752 ILD layers are separated from one another by a corresponding etch-stop layer 790 between adjacent ILD layers. In an embodiment, the first 702, second 712, third 722, fourth 732, fifth 742 and sixth 752 ILD layers include silicon, carbon and oxygen.

In an embodiment, individual ones of the first 704 and second 714 pluralities of conductive interconnect lines have a first width (W1). Individual ones of the third 724, fourth 734, fifth 744 and sixth 754 pluralities of conductive interconnect lines have a second width (W2) greater than the first width (W1).

It is to be appreciated that the layers and materials described above in association with back-end-of-line (BEOL) structures and processing may be formed on or above an underlying semiconductor substrate or structure, such as underlying device layer(s) of an integrated circuit. In an embodiment, an underlying semiconductor substrate represents a general workpiece object used to manufacture integrated circuits. The semiconductor substrate often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as substrates including germanium, carbon, or group III-V materials. The semiconductor substrate, depending on the stage of manufacture, often includes transistors, integrated circuitry, and the like. The substrate may also include semiconductor materials, metals, dielectrics, dopants, and other materials commonly found in semiconductor substrates. Furthermore, the structures depicted may be fabricated on underlying lower level interconnect layers.

Although the preceding methods of fabricating a metallization layer, or portions of a metallization layer, of a BEOL metallization layer are described in detail with respect to select operations, it is to be appreciated that additional or intermediate operations for fabrication may include standard microelectronic fabrication processes such as lithography, etch, thin films deposition, planarization (such as chemical mechanical polishing (CMP)), diffusion, metrology, the use of sacrificial layers, the use of etch stop layers, the use of planarization stop layers, or any other associated action with microelectronic component fabrication. Also, it is to be appreciated that the process operations described for the preceding process flows may be practiced in alternative sequences, not every operation need be performed or additional process operations may be performed or both.

In an embodiment, as used throughout the present description, interlayer dielectric (ILD) material is composed of or includes a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, various low-k dielectric materials known in the arts, and combinations thereof. The interlayer dielectric material may be formed by techniques, such as, for example, chemical vapor deposition (CVD), physical vapor deposition (PVD), or by other deposition methods.

In an embodiment, as is also used throughout the present description, metal lines or interconnect line material (and via material) is composed of one or more metal or other conductive structures. A common example is the use of copper lines and structures that may or may not include barrier layers between the copper and surrounding ILD material. As used herein, the term metal includes alloys, stacks, and other combinations of multiple metals. For example, the metal interconnect lines may include barrier layers (e.g., layers including one or more of Ta, TaN, Ti or TiN), stacks of different metals or alloys, etc. Thus, the interconnect lines may be a single material layer, or may be formed from several layers, including conductive liner layers and fill layers. Any suitable deposition process, such as electroplating, chemical vapor deposition or physical vapor deposition, may be used to form interconnect lines. In an embodiment, the interconnect lines are composed of a conductive material such as, but not limited to, Cu, Al, Ti, Zr, Hf, V, Ru, Co, Ni, Pd, Pt, W, Ag, Au or alloys thereof. The interconnect lines are also sometimes referred to in the art as traces, wires, lines, metal, or simply interconnect.

In an embodiment, as is also used throughout the present description, hardmask materials are composed of dielectric materials different from the interlayer dielectric material. In one embodiment, different hardmask materials may be used in different regions so as to provide different growth or etch selectivity to each other and to the underlying dielectric and metal layers. In some embodiments, a hardmask layer includes a layer of a nitride of silicon (e.g., silicon nitride) or a layer of an oxide of silicon, or both, or a combination thereof. Other suitable materials may include carbon-based materials. In another embodiment, a hardmask material includes a metal species. For example, a hardmask or other overlying material may include a layer of a nitride of titanium or another metal (e.g., titanium nitride). Potentially lesser amounts of other materials, such as oxygen, may be included in one or more of these layers. Alternatively, other hardmask layers known in the arts may be used depending upon the particular implementation. The hardmask layers maybe formed by CVD, PVD, or by other deposition methods.

In an embodiment, as is also used throughout the present description, lithographic operations are performed using 193nm immersion lithography (i193), extreme ultra-violet (EUV) lithography or electron beam direct write (EBDW) lithography, or the like. A positive tone or a negative tone resist may be used. In one embodiment, a lithographic mask is a tri-layer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

Embodiments disclosed herein may be used to manufacture a wide variety of different types of integrated circuits or microelectronic devices. Examples of such integrated circuits include, but are not limited to, processors, chipset components, graphics processors, digital signal processors, microcontrollers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

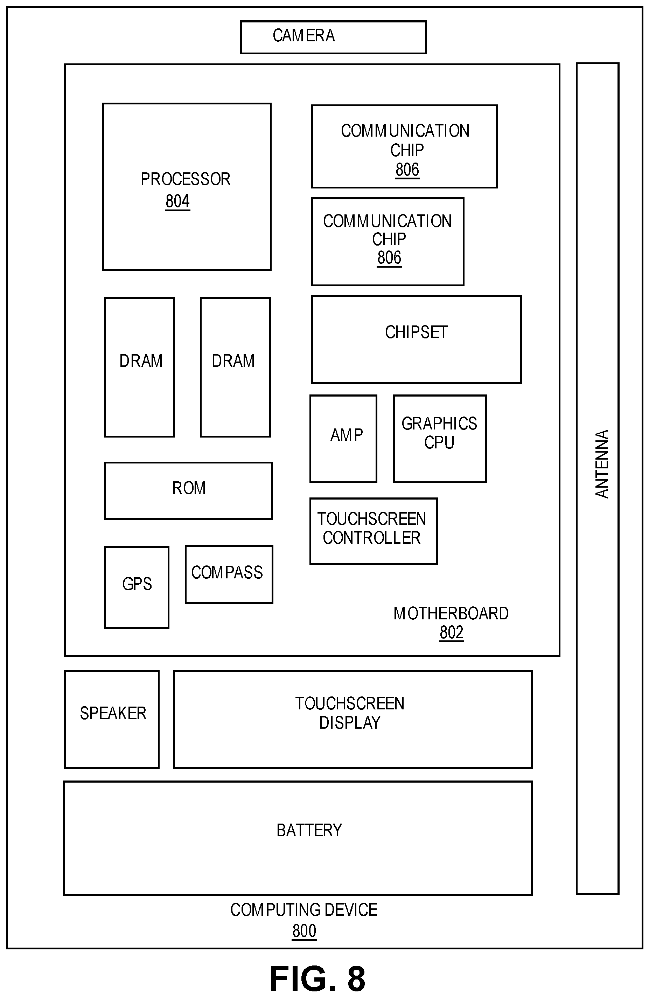

Figure 8 illustrates a computing device 800 in accordance with one implementation of the disclosure. The computing device 800 houses a board 802. The board 802 may include a number of components, including but not limited to a processor 7904 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

Depending on its applications, computing device 800 may include other components that may or may not be physically and electrically coupled to the board 802. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of embodiments of the disclosure, the integrated circuit die of the processor includes one or more structures, such as an integrated capacitor built in accordance with implementations of the disclosure. The term "processor" may refer to any device or portion of a device that processes electronic data from registers or memory to transform that electronic data, or both, into other electronic data that may be stored in registers or memory, or both.

The communication chip 806 also includes an integrated circuit die packaged within the communication chip 806. In accordance with another implementation of the disclosure, the integrated circuit die of the communication chip has an integrated capacitor built in accordance with implementations of the disclosure.

In further implementations, another component housed within the computing device 800 may contain an integrated circuit die having an integrated capacitor built in accordance with implementations of embodiments of the disclosure.

In various embodiments, the computing device 800 may be a laptop, a netbook, a notebook, an ultrabook, a smartphone, a tablet, a personal digital assistant (PDA), an ultramobile PC, a mobile phone, a desktop computer, a server, a printer, a scanner, a monitor, a set-top box, an entertainment control unit, a digital camera, a portable music player, or a digital video recorder. In further implementations, the computing device 800 may be any other electronic device that processes data.

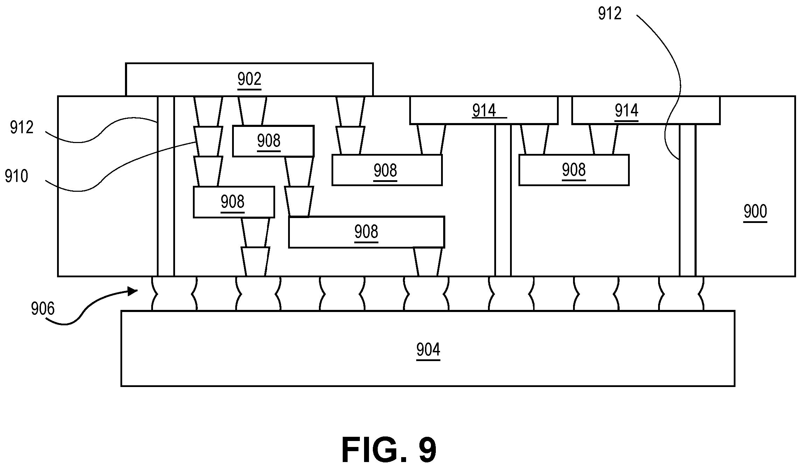

Figure 9 illustrates an interposer 900 that includes one or more embodiments of the disclosure. The interposer 900 is an intervening substrate used to bridge a first substrate 902 to a second substrate 904. The first substrate 902 may be, for instance, an integrated circuit die. The second substrate 904 may be, for instance, a memory module, a computer motherboard, or another integrated circuit die. Generally, the purpose of an interposer 900 is to spread a connection to a wider pitch or to reroute a connection to a different connection. For example, an interposer 900 may couple an integrated circuit die to a ball grid array (BGA) 906 that can subsequently be coupled to the second substrate 904. In some embodiments, the first and second substrates 902/904 are attached to opposing sides of the interposer 900. In other embodiments, the first and second substrates 902/904 are attached to the same side of the interposer 900. And, in further embodiments, three or more substrates are interconnected by way of the interposer 900.

The interposer 900 may be formed of an epoxy resin, a fiberglass-reinforced epoxy resin, a ceramic material, or a polymer material such as polyimide. In further implementations, the interposer 900 may be formed of alternate rigid or flexible materials that may include the same materials described above for use in a semiconductor substrate, such as silicon, germanium, and other group III-V and group IV materials.

The interposer 900 may include metal interconnects 908 and vias 910, including but not limited to through-silicon vias (TSVs) 912. The interposer 900 may further include embedded devices 914, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 900. In accordance with embodiments of the disclosure, apparatuses or processes disclosed herein may be used in the fabrication of interposer 900 or in the fabrication of components included in the interposer 900.

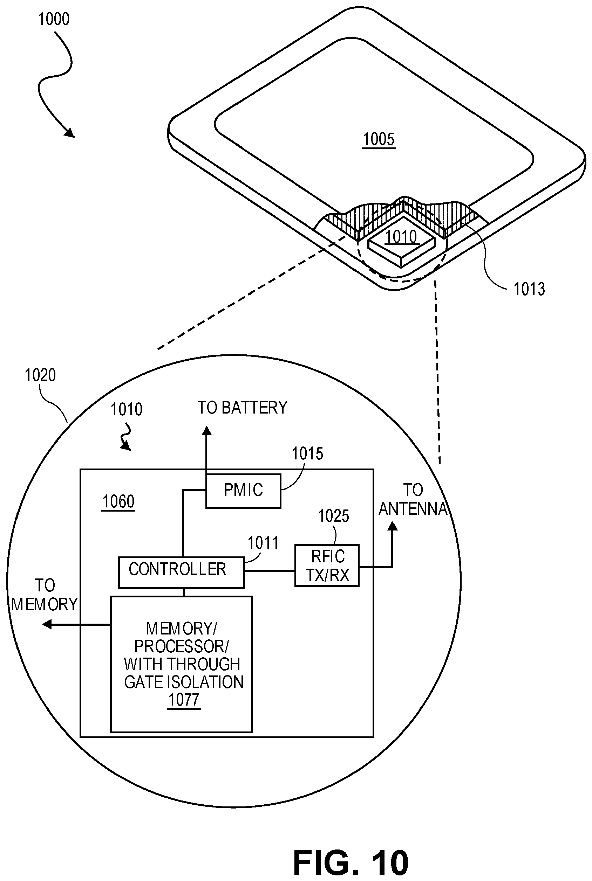

Figure 10 is an isometric view of a mobile computing platform 1000 employing an integrated circuit (IC) fabricated according to one or more processes described herein or including one or more features described herein, in accordance with an embodiment of the present disclosure.

The mobile computing platform 1000 may be any portable device configured for each of electronic data display, electronic data processing, and wireless electronic data transmission. For example, mobile computing platform 1000 may be any of a tablet, a smart phone, laptop computer, etc. and includes a display screen 1005 which in the exemplary embodiment is a touchscreen (capacitive, inductive, resistive, etc.), a chip-level (SoC) or package-level integrated system 1010, and a battery 1013. As illustrated, the greater the level of integration in the system 1010 enabled by higher transistor packing density, the greater the portion of the mobile computing platform 1000 that may be occupied by the battery 1013 or non-volatile storage, such as a solid state drive, or the greater the transistor gate count for improved platform functionality. Similarly, the greater the carrier mobility of each transistor in the system 1010, the greater the functionality. As such, techniques described herein may enable performance and form factor improvements in the mobile computing platform 1000.

The integrated system 1010 is further illustrated in the expanded view 1020. In the exemplary embodiment, packaged device 1077 includes at least one memory chip (e.g., RAM), or at least one processor chip (e.g., a multi-core microprocessor and/or graphics processor) fabricated according to one or more processes described herein or including one or more features described herein. The packaged device 1077 is further coupled to the board 1060 along with one or more of a power management integrated circuit (PMIC) 1015, RF (wireless) integrated circuit (RFIC) 1025 including a wideband RF (wireless) transmitter and/or receiver (e.g., including a digital baseband and an analog front end module further includes a power amplifier on a transmit path and a low noise amplifier on a receive path), and a controller thereof 1011. Functionally, the PMIC 1015 performs battery power regulation, DC-to-DC conversion, etc., and so has an input coupled to the battery 1013 and with an output providing a current supply to all the other functional modules. As further illustrated, in the exemplary embodiment, the RFIC 1025 has an output coupled to an antenna to provide to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. In alternative implementations, each of these board-level modules may be integrated onto separate ICs coupled to the package substrate of the packaged device 1077 or within a single IC (SoC) coupled to the package substrate of the packaged device 1077.

In another aspect, semiconductor packages are used for protecting an integrated circuit (IC) chip or die, and also to provide the die with an electrical interface to external circuitry. With the increasing demand for smaller electronic devices, semiconductor packages are designed to be even more compact and must support larger circuit density. Furthermore, the demand for higher performance devices results in a need for an improved semiconductor package that enables a thin packaging profile and low overall warpage compatible with subsequent assembly processing.

In an embodiment, wire bonding to a ceramic or organic package substrate is used. In another embodiment, a C4 process is used to mount a die to a ceramic or organic package substrate. In particular, C4 solder ball connections can be implemented to provide flip chip interconnections between semiconductor devices and substrates. A flip chip or Controlled Collapse Chip Connection (C4) is a type of mounting used for semiconductor devices, such as integrated circuit (IC) chips, MEMS or components, which utilizes solder bumps instead of wire bonds. The solder bumps are deposited on the C4 pads, located on the top side of the substrate package. In order to mount the semiconductor device to the substrate, it is flipped over with the active side facing down on the mounting area. The solder bumps are used to connect the semiconductor device directly to the substrate.

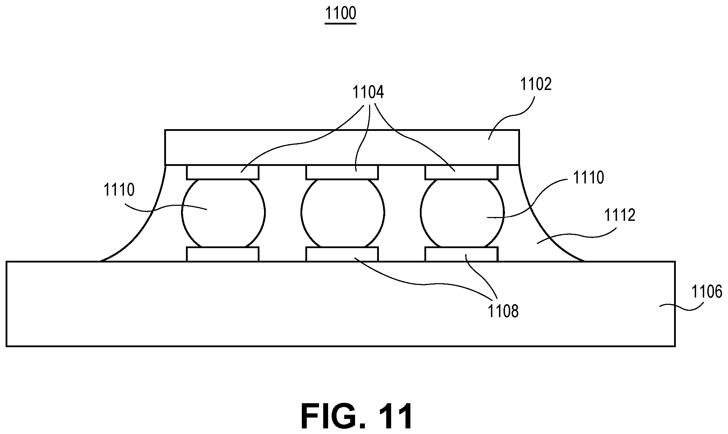

Figure 11 illustrates a cross-sectional view of a flip-chip mounted die, in accordance with an embodiment of the present disclosure.

Referring to Figure 11, an apparatus 1100 includes a die 1102 such as an integrated circuit (IC) fabricated according to one or more processes described herein or including one or more features described herein, in accordance with an embodiment of the present disclosure. The die 1102 includes metallized pads 1104 thereon. A package substrate 1106, such as a ceramic or organic substrate, includes connections 1108 thereon. The die 1102 and package substrate 1106 are electrically connected by solder balls 1110 coupled to the metallized pads 1104 and the connections 1108. An underfill material 1112 surrounds the solder balls 1110.

Processing a flip chip may be similar to conventional IC fabrication, with a few additional operations. Near the end of the manufacturing process, the attachment pads are metalized to make them more receptive to solder. This typically consists of several treatments. A small dot of solder is then deposited on each metalized pad. The chips are then cut out of the wafer as normal. To attach the flip chip into a circuit, the chip is inverted to bring the solder dots down onto connectors on the underlying electronics or circuit board. The solder is then re-melted to produce an electrical connection, typically using an ultrasonic or alternatively reflow solder process. This also leaves a small space between the chip's circuitry and the underlying mounting. In most cases an electrically-insulating adhesive is then "underfilled" to provide a stronger mechanical connection, provide a heat bridge, and to ensure the solder joints are not stressed due to differential heating of the chip and the rest of the system.

In other embodiments, newer packaging and die-to-die interconnect approaches, such as through silicon via (TSV) and silicon interposer, are implemented to fabricate high performance MultiChip Module (MCM) and System in Package (SiP) incorporating an integrated circuit (IC) fabricated according to one or more processes described herein or including one or more features described herein, in accordance with an embodiment of the present disclosure.

Thus, embodiments of the present disclosure include integrated capacitors.

## Claims

1. An integrated capacitor structure (200), comprising:
alternating first metal lines (202) and second metal lines (204) in a dielectric layer of a metallization layer in a stack of metallization layers, the first metal lines (202) coupled together, and the second metal lines (204) coupled together;
a metal plate (208) over the alternating first metal lines (202) and second metal lines (204); and
a dielectric liner layer (206) between the alternating first metal lines (202) and second metal lines (204) and the metal plate (208), **characterized in that** the dielectric liner layer (206) has a thickness (t) of between 4.5 nanometres and 5.5 nanometres.

2. The integrated capacitor structure (200) of claim 1, wherein the dielectric liner (206) has a dielectric constant greater than a dielectric constant of the dielectric layer.

3. The integrated capacitor structure (200) claim 1 or 2, wherein the first metal lines (202) are coupled to a first polarity, and the second metal lines (204) are coupled to a second polarity opposite the first polarity.

4. The integrated capacitor structure (200) claim 3, wherein the metal plate (208) is electrically floating.

5. The integrated capacitor structure (200) claim 1, 2, 3 or 4, wherein the alternating first metal lines (202) and second metal lines (204) and the dielectric layer form a finger capacitor structure.

6. A method of fabricating an integrated capacitor structure (200), the method comprising:
forming alternating first metal lines (202) and second metal lines (204) in a dielectric layer of a metallization layer in a stack of metallization layers, the first metal lines (202) coupled together, and the second metal lines (204) coupled together;
forming a metal plate (208) over the alternating first metal lines (202) and second metal lines (204); and
forming a dielectric liner layer (206) between the alternating first metal lines (202) and second metal lines (204) and the metal plate (208), **characterized in that** the dielectric liner layer (206) has a thickness (t) of between 4.5 nanometres and 5.5 nanometres.

7. The method of claim 6, wherein the dielectric liner (206) has a dielectric constant greater than a dielectric constant of the dielectric layer.

8. The method of claim 6 or 7, wherein the first metal lines (202) are coupled to a first polarity, and the second metal lines (204) are coupled to a second polarity opposite the first polarity.

9. The method of claim 8, wherein the metal plate (208) is electrically floating.

10. The method of claim 6, 7, 8 or 9, wherein the alternating first metal lines (202) and second metal lines (204) and the dielectric layer form a finger capacitor structure.

## Patentansprüche

1. Integrierte Kondensatorstruktur (200), die Folgendes umfasst:
alternierende erste Metallleitungen (202) und zweite Metallleitungen (204) in einer dielektrischen Schicht einer Metallisierungsschicht in einem Stapel von Metallisierungsschichten, wobei die ersten Metallleitungen (202) miteinander gekoppelt sind und die zweiten Metallleitungen (204) miteinander gekoppelt sind;
eine Metallplatte (208) über den alternierenden ersten Metallleitungen (202) und zweiten Metallleitungen (204); und
eine dielektrische Auskleidungsschicht (206) zwischen den alternierenden ersten Metallleitungen (202) und zweiten Metallleitungen (204) und der Metallplatte (208), **dadurch gekennzeichnet, dass** die dielektrische Auskleidungsschicht (206) eine Dicke (t) zwischen 4,5 Nanometern und 5,5 Nanometern aufweist.

2. Integrierte Kondensatorstruktur (200) nach Anspruch 1, wobei die dielektrische Auskleidung (206) eine Dielektrizitätskonstante aufweist, die größer als eine Dielektrizitätskonstante der dielektrischen Schicht ist.

3. Integrierte Kondensatorstruktur (200) nach Anspruch 1 oder 2, wobei die ersten Metallleitungen (202) mit einer ersten Polarität gekoppelt sind und die zweiten Metallleitungen (204) mit einer der ersten Polarität entgegengesetzten zweiten Polarität gekoppelt sind.

4. Integrierte Kondensatorstruktur (200) nach Anspruch 3, wobei die Metallplatte (208) elektrisch potenzialfrei ist.

5. Integrierte Kondensatorstruktur (200) nach Anspruch 1, 2, 3 oder 4, wobei die alternierenden ersten Metallleitungen (202) und zweiten Metallleitungen (204) und die dielektrische Schicht eine Fingerkondensatorstruktur bilden.

6. Verfahren zum Fertigen einer integrierten Kondensatorstruktur (200), wobei das Verfahren Folgendes umfasst:
Bilden alternierender erster Metallleitungen (202) und zweiter Metallleitungen (204) in einer dielektrischen Schicht einer Metallisierungsschicht in einem Stapel von Metallisierungsschichten, wobei die ersten Metallleitungen (202) miteinander gekoppelt sind und die zweiten Metallleitungen (204) miteinander gekoppelt sind;
Bilden einer Metallplatte (208) über den alternierenden ersten Metallleitungen (202) und zweiten Metallleitungen (204); und
Bilden einer dielektrischen Auskleidungsschicht (206) zwischen den alternierenden ersten Metallleitungen (202) und zweiten Metallleitungen (204) und der Metallplatte (208), **dadurch gekennzeichnet, dass** die dielektrische Auskleidungsschicht (206) eine Dicke (t) zwischen 4,5 Nanometern und 5,5 Nanometern aufweist.

7. Verfahren nach Anspruch 6, wobei die dielektrische Auskleidung (206) eine Dielektrizitätskonstante aufweist, die größer als eine Dielektrizitätskonstante der dielektrischen Schicht ist.

8. Verfahren nach Anspruch 6 oder 7, wobei die ersten Metallleitungen (202) mit einer ersten Polarität gekoppelt sind und die zweiten Metallleitungen (204) mit einer der ersten Polarität entgegengesetzten zweiten Polarität gekoppelt sind.

9. Verfahren nach Anspruch 8, wobei die Metallplatte (208) elektrisch potenzialfrei ist.

10. Verfahren nach Anspruch 6, 7, 8 oder 9, wobei die alternierenden ersten Metallleitungen (202) und zweiten Metallleitungen (204) und die dielektrische Schicht eine Fingerkondensatorstruktur bilden.

## Revendications

1. Structure de condensateur intégré (200) comprenant :
une alternance de premières lignes métalliques (202) et de deuxièmes lignes métalliques (204) dans une couche diélectrique d'une couche de métallisation dans un empilement de couches de métallisation, les premières lignes métalliques (202) étant couplées entre elles, et les deuxièmes lignes métalliques (204) étant couplées entre elles ;
une plaque métallique (208) sur l'alternance de premières lignes métalliques (202) et de deuxièmes lignes métalliques (204) ; et
une couche de revêtement diélectrique (206) entre l'alternance de premières lignes métalliques (202) et de deuxièmes lignes métalliques (204) et la plaque métallique (208), **caractérisée en ce que** la couche de revêtement diélectrique (206) présente une épaisseur (t) comprise entre 4,5 nanomètres et 5,5 nanomètres.

2. Structure de condensateur intégré (200) selon la revendication 1, dans laquelle le revêtement diélectrique (206) a une constante diélectrique supérieure à une constante diélectrique de la couche diélectrique.

3. Structure de condensateur intégré (200) selon la revendication 1 ou la revendication 2, dans laquelle les premières lignes métalliques (202) sont couplées à une première polarité, et les deuxièmes lignes métalliques (204) sont couplées à une deuxième polarité opposée à la première polarité.

4. Structure de condensateur intégré (200) selon la revendication 3, dans lequel la plaque métallique (208) est électriquement flottante.

5. Structure de condensateur intégré (200) selon les revendications 1, 2, 3 ou 4, dans laquelle l'alternance de premières lignes métalliques (202) et de deuxièmes lignes métalliques (204) et la couche diélectrique forment une structure de condensateur à peigne.

6. Procédé de fabrication d'une structure de condensateur intégré (200), le procédé comprenant :
la formation d'une alternance de premières lignes métalliques (202) et de deuxièmes lignes métalliques (204) dans une couche diélectrique d'une couche de métallisation dans un empilement de couches de métallisation, les premières lignes métalliques (202) étant couplées entre elles, et les deuxièmes lignes métalliques (204) étant couplées entre elles ;
la formation d'une plaque métallique (208) sur l'alternance de premières lignes métalliques (202) et de deuxièmes lignes métalliques (204) ; et
la formation d'une couche de revêtement diélectrique (206) entre l'alternance de premières lignes métalliques (202) et de deuxièmes lignes métalliques (204) et la plaque métallique (208), **caractérisée en ce que** la couche de revêtement diélectrique (206) présente une épaisseur (t) comprise entre 4,5 nanomètres et 5,5 nanomètres.

7. Procédé selon la revendication 6, dans lequel le revêtement diélectrique (206) a une constante diélectrique supérieure à une constante diélectrique de la couche diélectrique.

8. Procédé selon la revendication 6 ou la revendication 7, dans lequel les premières lignes métalliques (202) sont couplées à une première polarité, et les deuxièmes lignes métalliques (204) sont couplées à une deuxième polarité opposée à la première polarité.

9. Procédé selon la revendication 8, dans lequel la plaque métallique (208) est électriquement flottante.

10. Procédé selon les revendications 6, 7, 8 ou 9, dans lequel l'alternance de premières lignes métalliques (202) et de deuxièmes lignes métalliques (204) et la couche diélectrique forment une structure de condensateur à peigne.
